# EUROPEAN PATENT SPECIFICATION

(11) **EP 2 896 653 B1**
(45) Date of publication and mention of the grant of the patent: **31.05.2017**
(21) Application number: 12884451.1
(22) Date of filing: 14.09.2012
(51) Int. Cl.: C08L 63/00, C08G 59/32, C08G 59/42, C08K 5/49, B32B 15/092, B32B 27/04

(54) **EPOXY RESIN COMPOSITION, AND, PREPREG AND COPPER CLAD LAMINATE MANUFACTURED USING THE COMPOSITION**
EPOXIDHARZZUSAMMENSETZUNG SOWIE DARAUS HERGESTELLTES PREPREG UND KUPFERKASCHIERTES LAMINAT
COMPOSITION DE RÉSINE ÉPOXY AINSI QUE STRATIFIÉ DE PRÉ-IMPRÉGNÉ ET DE CUIVRE FABRIQUÉ À L'AIDE DE LA COMPOSITION

(43) Date of publication of application: 22.07.2015
(73) Proprietor: Shengyi Technology Co., Ltd, Dongguan, Guangdong 523808 (CN)
(72) Inventor: ZENG, Xianping, Guangdong 523808 (CN); REN, Nana, Guangdong 523808 (CN)
(74) Representative: Ricker, Mathias
(86) International application number: PCT/CN2012/081368
(87) International publication number: WO 2014/040262

(56) References cited:
- CN-A- 102 300 901
- CN-A- 102 443 138
- CN-A- 102 838 841
- CN-A- 102 838 842
- JP-A- 2003 082 063
- JP-A- 2009 242 559
- US-A1- 2008 241 578

## Description

### Technical field

The present invention relates to the field of printed circuit boards, especially to a halogen-free epoxy resin composition, and a prepreg and a copper-clad laminate made by using same.

### Background art

Along with the high speed and multi-functionalization in information processing of electronic products, applying frequency constantly increases and 3-6 GHz will become a mainstream. Except for maintaining higher requirements for heat resistance of laminate materials, requirements for their dielectric constant and dissipation factor may be increasingly. Existing conventional epoxy glass fiber cloth laminates (FR-4) can hardly satisfy the use demand for high frequency and high speed development of electronic products, meanwhile baseboard materials no longer play a part as a mechanical support under traditional meaning, but as a printed circuit board (PCB) and an important approach to improve product performances by terminal manufacturer designers together with electronic components. Since a high dielectric constant (DK) may lower the signal transmission rate and a high dielectric loss value (Df) can make the signal partially transform into heat energy lost in the baseboard materials, reducing the dielectric constant/ dielectric loss value has been a popular focus for baseboard providers. Conditional epoxy glass fiber cloth laminate materials generally employ dicyandiamide as a hardener. Such hardener possesses good processing operability due to having a three-stage reactive amine. However, as its carbon- nitrogen bond is weak, likely to crack at a high temperature, the pyrolysis temperature of cured products is resulting low, which is unable to meet the heat resistance requirement of lead-free process. Under this background, along with the large scale implementation of the lead-free process in 2006, phenolic resins were started to be used as epoxy resin hardeners in the industry. Phenolic resins have a benzene ring heat resisting structure of high density, therefore the heat resistance of post-curing system of epoxy resins is excellent but simultaneously there emerges a trend of degeneration in dielectric performances of cured products

Japanese patents 2002-012650 and 2003-082063 have put forward synthesizing a series of active ester hardeners containing benzene ring, naphthalene ring or diphenyl structures such as IAAN, IABN, TriABN and TAAN, as hardeners for epoxy resins. The resulting cured products can obviously decrease the dielectric constant and dielectric loss value thereof compared to traditional phenolic resins.

Japanese patent 2003-252958 has put forward that employing diphenyl-type epoxy resins and active esters as hardeners may obtain cured products with decreased dielectric constant and dielectric loss value. However, since the epoxy resins in use are bifunctional and the curing cross-linking density of the active esters is small, the heat resistance of cured products is low as well as the glass transition temperature.

Japanese patent 2004-155990 uses aromatic carboxylic acids to be reacted with aromatic phenols to obtain an active ester hardener with multiple functionality .Using the active ester hardener to cure novolac epoxy resins can obtain cured products with higher heat resistance, lower dielectric constant and dielectric loss value.

Japanese patent 2009-235165 has put forward a novel multiple functionality active ester hardener, which cures an epoxy resin containing an aliphatic structure, thereby obtaining cured products having higher glass transition temperature and lower dielectric constant and dielectric loss value simultaneously.
Japanese patent 2009-040919 has put forward a thermosetting resin composition with stable dielectric constant and excellent adhesion of conductive layer, the main components of which include an epoxy resin, an active ester hardener, a curing accelerator and an organic solvent. The resulting cured products have good adhesion to copper foil, low dielectric constant and dielectric loss value. It has studied on the amounts of the epoxy resin and the active ester but has not studied on the relationship between structure and performance of the epoxy resin and the active ester.
In addition, Japanese patents 2009-242559, 2009-242560, 2010-077344 and 2010-077343 have put forward respectively employing alkylated phenol or alkylated naphthol novolac epoxy resins and biphenyl novolac epoxy resins, using active esters as a hardener, can obtain cured products with low hygroscopicity and low dielectric constant and dielectric loss tangent value. Further compositions useful for the preparation of prepregs and comprising multi-functional epoxy resins together with an actived-ester hardening agent are disclosed in CN 102300901 A.

In these current patent technologies above, though all have put forward that using an active ester as epoxy resin hardener can improve the moisture resistance of the cured products, lower the water absorption rate and reduce the dielectric constant and dielectric loss value of the cured products, the disadvantage thereof is the difficulty in getting a good balance between heat resistance and dielectric performance, which allows the cured products to possess simultaneously a high glass transition temperature and low dielectric loss tangent value, and also allows the dielectric performance to be stable with the variations in frequency and a lower water absorption rate. Meanwhile no studies have been made on how to realize the halogen-free flame retardancy of cured products.

### Contents of the invention

An object of the present invention lies in providing an epoxy resin composition, which is able to provide excellent dielectric performance, humidity resistant performance required by copper-clad laminates and realizes halogen-free flame retardancy, achieving UL 94V-0.

Another object of the present invention lies in providing a prepreg and a copper-clad laminate made by using the above mentioned epoxy resin composition, which have excellent dielectric performance and moisture-heat resistant performance, simultaneously have a high glass transition temperature and a lower water absorption rate and simultaneously realize halogen-free flame retardancy, achieving UL-94V.

In order to achieve these objects above, the present invention provides an epoxy resin composition comprising components as follows: an epoxy resin comprising 3 or more epoxy groups and containing nitrogen in the molecular chain, a phosphorus-containing halogen-free flame retardant compound and an active ester hardener; the amount of the epoxy resin comprising 3 or more epoxy groups and containing nitrogen in the molecular chain is 100 parts by weight, the amount of the phosphorus-containing halogen-free flame retardant compound is 10-150 parts by weight. The equivalent ratio of the amount of the active ester hardener, based on the ratio between epoxy equivalent and active ester equivalent, is 0.85-1.2.

The epoxy resin comprising 3 or more epoxy groups and containing nitrogen in the molecular chain is at least one of the epoxy resins having the following structural formula:

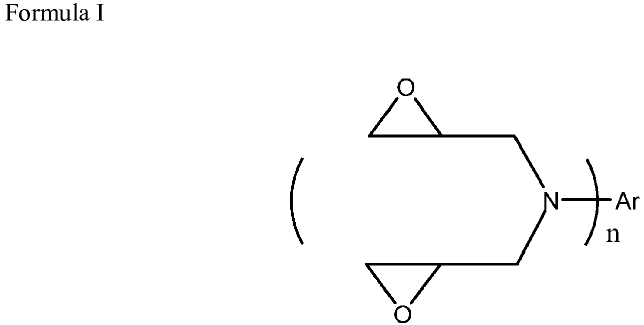

Wherein, n is an integer of 1∼3; Ar is: 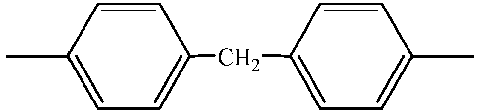 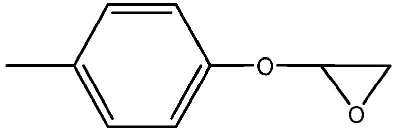 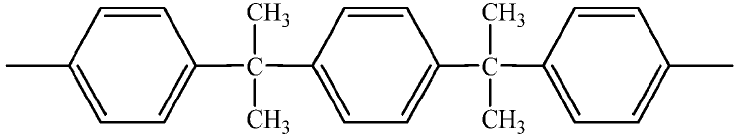 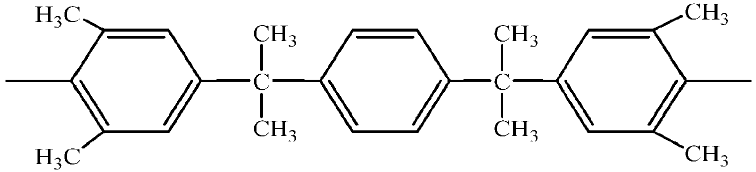 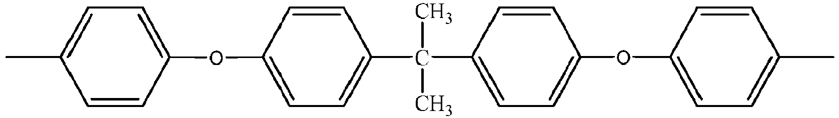 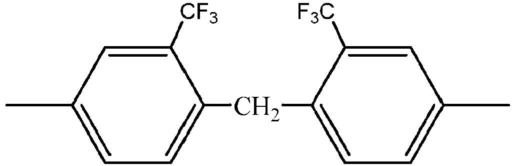 or

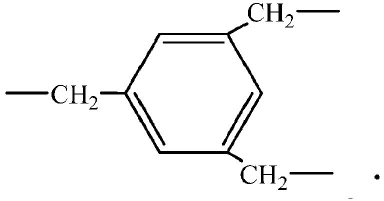

The active ester hardener is obtained by reacting a phenolic compound linked by an aliphatic cyclic hydrocarbon structure, a bifunctional carboxylic acid aromatic compound or an acidic halide with a mono-hydroxyl compound.

The amount of the bifunctional carboxylic acid aromatic compound or the acidic halide is 1 mol. The amount of the phenolic compound linked by an aliphatic cyclic hydrocarbon structure is 0.05∼0.75mol. The amount of the mono-hydroxyl compound is 0.25∼0.95mol.

The active ester hardener has the following structural formula:

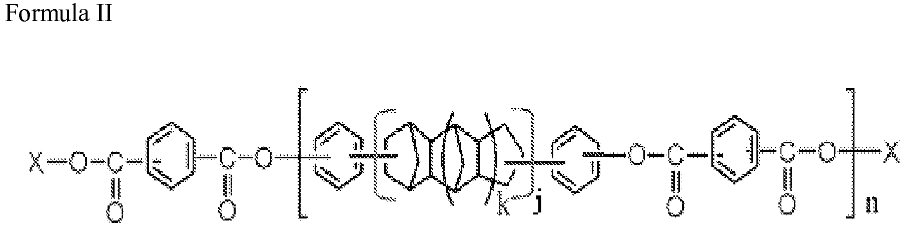

Wherein, X is a benzene ring or naphthalene ring, j is 0 or 1, k is 0 or 1, n is 0.25-2.5.

The phosphorus-containing halogen-free flame retardant compound is one or a mixture of phosphate ester compounds, phosphate salt compounds, phosphazene compounds, phosphaphenanthrene compounds and derivatives thereof, phosphorus-containing phenolic resins and phosphurated polycarbonates; the phosphorus content of the phosphorus-containing halogen-free flame retardant compound is 5∼30% by weight.

Further, the epoxy resin composition also comprises a curing accelerator. The curing accelerator is one or a mixture of imidazoles and derivatives thereof, piperidine compounds, Lewis acids and triphenylphosphine.

Still further, the epoxy resin composition also comprises an organic filler, an inorganic filler or a mixture of organic filler and inorganic filler. The amount of the filler, relative to the total 100 parts by weight of the epoxy resin, the active ester hardener and the phosphorus-containing halogen-free flame retardant compound, is 5∼500 parts by weight.

The inorganic filler is one or more selected from crystalline silica, melting silica, spherical silica, hollow silica, glass powder, aluminum nitride, boron nitride, silicon carbide, aluminum hydroxide, titanium dioxide, strontium titanate, barium titanate, aluminum oxide, barium sulfate, talcum powder, calcium silicate, calcium carbonate and mica; the organic filler is one or more selected from polytetrafluoroethylene powder, polyphenylene sulfide and polyether sulfone powder.

Meanwhile, the present invention also provides a prepreg made by using the epoxy resin composition above, including a reinforce material and the epoxy resin composition attached thereon after being impregnated and dried.

Further, the present invention also provides a copper-clad laminate made by using the prepreg above, comprising several laminated prepregs and copper foils covered on one or both sides of the laminated pregregs.

The beneficial effects of the present invention: firstly, the epoxy resin composition described in the present invention employs the epoxy resin containing nitrogen in the molecular chain, which has higher functionality. As containing nitrogen, it can exhibit synergistic flame retardant effect together with the phosphorus in the active ester hardener, and can reach flame retardant requirements in a condition of minimizing using phosphorus flame retardant at the same time of providing high heat resistance; additionally, the epoxy resin compositon of the present invention uses active ester as a hardener, which fully exerts the advantage of that reacting active ester and epoxy resin does not generate polar groups thereby the dielectric performance is excellent and moisture-heat resistance is good, and uses the phosphorus-containing flame retardant of specific structure, which realizes halogen-free flame retardancy without losing the heat resistance, low water absorption and excellent dielectric performance of the original cured products. The flame retardancy of the cured products reaches UL94V-0 degree; finally, the prepreg and copper-clad laminate made by using the abovementioned epoxy resin composition of the invention have excellent dielectric performance and moisture-heat resistance, the flame retardancy of which reaches UL94V-0 degree.

### Embodiments

For further illustrating the technology means adopted by the present invention and the effects thereof, hereinafter it is detailed described in combination with preferred embodiments of the present invention.

The present invention provides an epoxy resin composition, comprising components as follows: an epoxy resin comprising 3 or more epoxy groups and containing nitrogen in the molecular chain, a phosphorus-containing halogen-free flame retardant compound and an active ester hardener.

The epoxy resin comprising 3 or more epoxy groups and containing nitrogen in the molecular chain is at least one of the epoxy resins having the following structural formula:

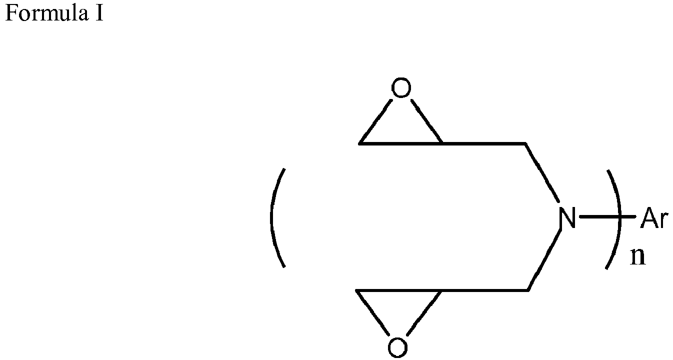

Wherein, n is an integer of 1∼3, Ar is: 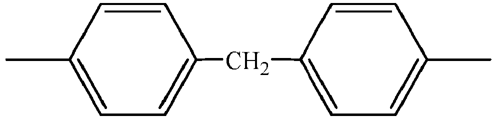 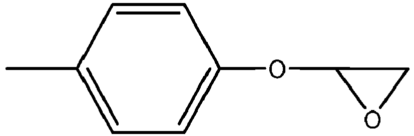 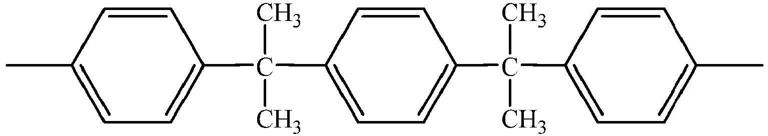 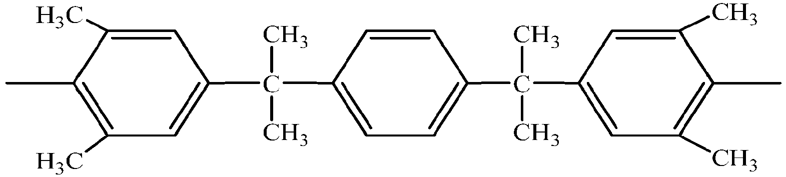 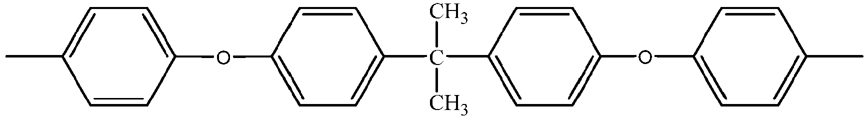 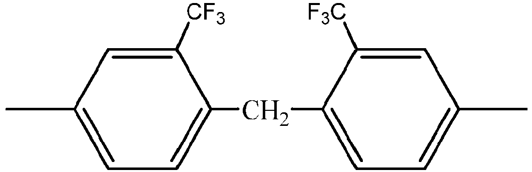 or

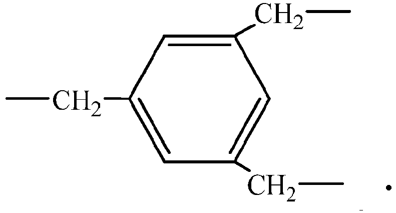

The structural formula of the nitrogen-containing epoxy resin of the present invention is specifically as follow:

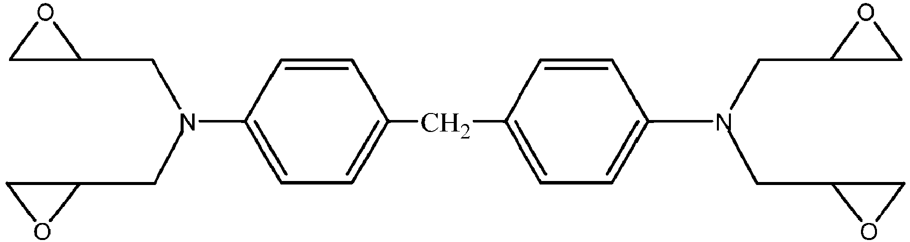

The structural formula of the nitrogen-containing epoxy resin of the present invention specifically may also be as follow:

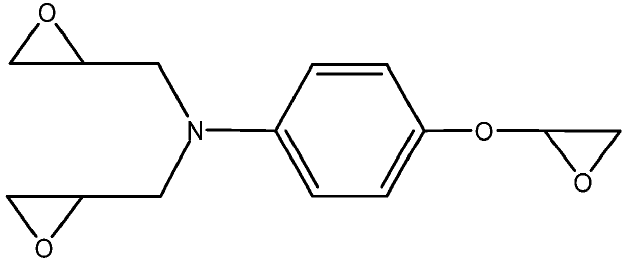

The structural formula of the nitrogen-containing epoxy resin of the present invention specifically may also be as follow:

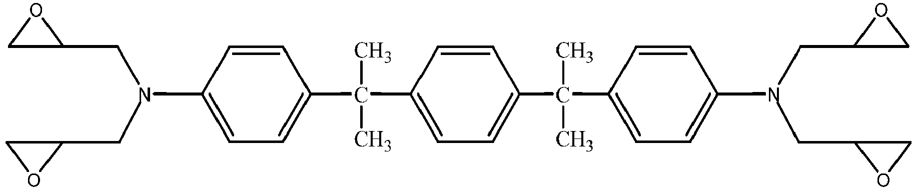

The structural formula of the nitrogen-containing epoxy resin of the present invention specifically may also be as follow:

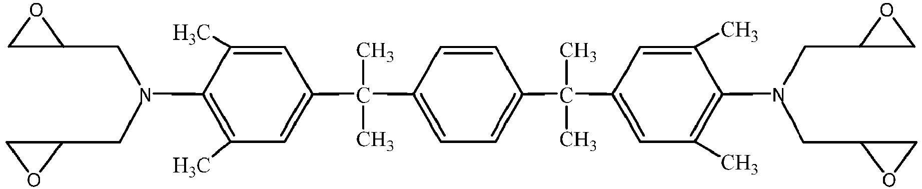

The structural formula of the nitrogen-containing epoxy resin of the present invention specifically may also be as follow:

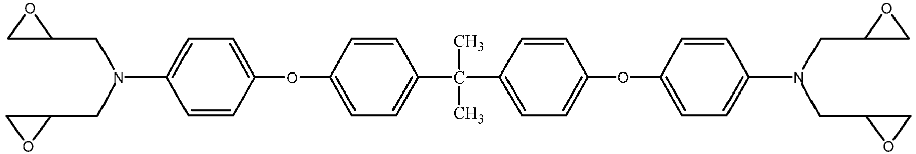

The structural formula of the nitrogen-containing epoxy resin of the present invention specifically may also be as follow:

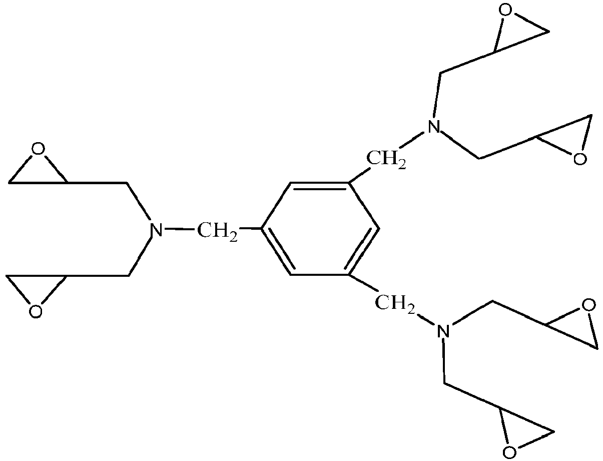

The structural formula of the nitrogen-containing epoxy resin of the present invention specifically may also be as follow:

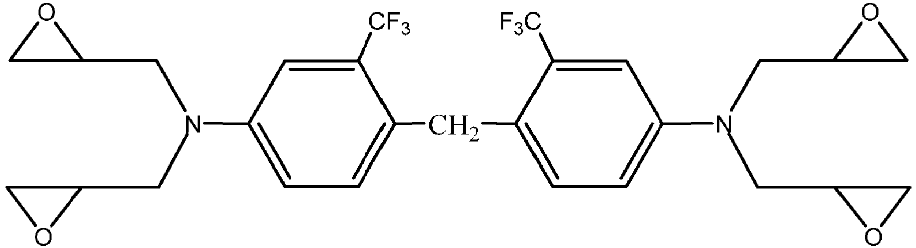

In the epoxy resin composition of the present invention, the active ester hardener is obtained by reacting a phenolic compound linked by an aliphatic cyclic hydrocarbon structure and a bifictionality carboxylic acid aromatic compound or an acidic halide and a mono-hydroxyl compound. The active ester mainly functions on curing the epoxy resin. Since no additional hydroxyl group is generated after the curing of the epoxy resin with it, basically no hydroxyl polar group is existed in the cured products, thus having good dielectric performance and low water absorption and good moisture-heat resistance.

The amount of the bifunctional carboxylic acid aromatic compound or the acidic halide is 1 mol. The amount of the phenolic compound linked by an aliphatic cyclic hydrocarbon structure is 0.05∼0.75mol. The amount of the mono-hydroxyl compound is 0.25∼0.95mol.

The bifunctional carboxylic compound can be a compound having following structural formula:

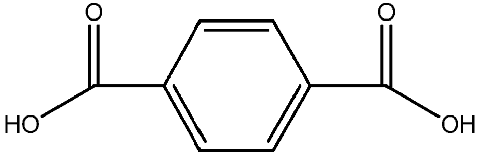

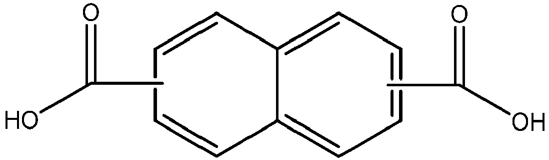

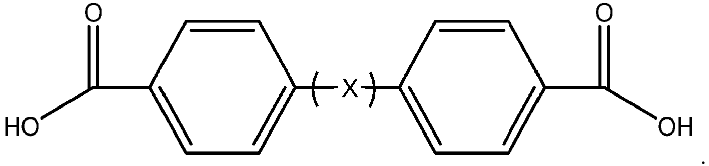

The structure of the phenolic compound linked by an aliphatic cyclic hydrocarbon structure is as follows: 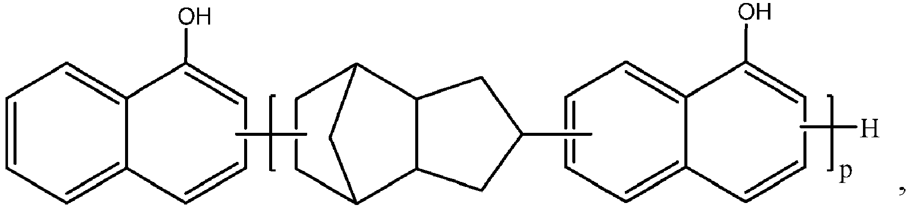 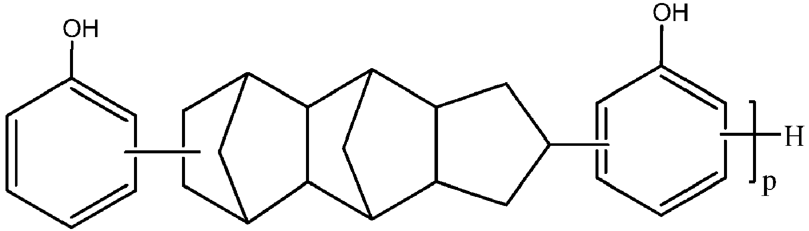 or

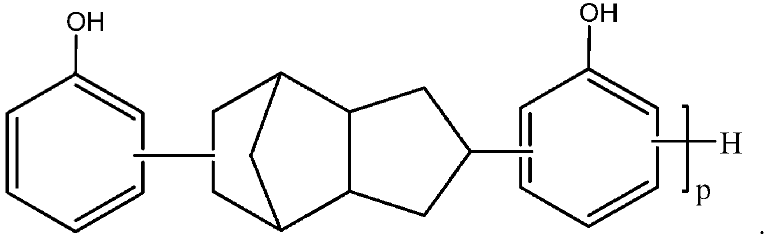

The structure of the active ester hardener is as follow:

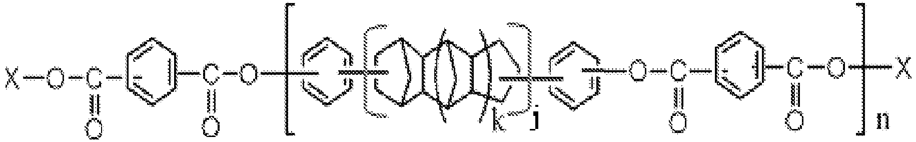

Wherein, X is a benzene ring or naphthalene ring, j is 0 or 1, k is 0 or 1, n is 0.25-2.5.

The amount of the active ester hardener, based on 100 parts by weight of the epoxy resin comprising 3 or more epoxy groups and containing nitrogen in the molecular chain, and also based on the ratio between epoxy equivalent and active ester equivalent, the equivalent ratio is 0.85∼1.2, preferred to be 0.9∼1.1, and more preferred to be 0.95∼1.05.

In the epoxy resin composition of the present invention, the phosphorus-containing halogen-free flame retardant compound is one or a mixture of phosphate ester compounds, phosphate salt compounds, phosphazene compounds, phosphaphenanthrene compounds and derivatives thereof, phosphorus-containing phenolic resins and phosphureted polycarbonates; the phosphorus content of the phosphorus-containing halogen-free flame retardant compound is 5∼30% by weight.

The phosphate ester compounds can be selected from aromatic phosphate ester compounds, specifically from resorcinol-bis(diphenyl phosphate), bisphenol-A-bis(diphenyl phosphate), resorcinol-bis(phosphoric acid-2, 6-dimethyl phenyl ester), or biphenol-bis(phosphoric acid-2, 6-dimethyl phenyl ester). Available commercialized products are, for instance, CR-741, PX-200, PX-202, etc; the phosphazene compounds can be selected from phosphonitrilic trimer or phosphonitrilic tetramer, optional commercialized products have SPB-100; the phosphaphenanthrene compounds and derivatives thereof can be 9,10-dihydro-9-oxa-10-phosphaphenanthrene-10-oxide, tri(2,6-dimethyl phenyl) phosphine, 10-(2,5- dihydroxy phenyl)-9,10-dihydro-9-oxa-10-phosphaphenanthrene-10-oxide, 2,6-bis(2,6-dimethyl phenyl) phosphinobenzene or 10-pheny-9,10-dihydro-9-oxa-10-phosphaphenanthrene-10-oxide; the phosphorus-containing phenolic resins can be phenol formaledlyde modified by 9,10-dihydro-9-oxa-10-phosphaphenanthrene-10-oxide, the phenol formaledlyde can be selected from linear phenol formaledlyde, o-cresol phenol formaledlyde, bisphenol-A phenol formaledlyde, biphenyl phenol formaledlyde, aralkyl phenol formaledlyde or multifunctional phenol formaledlyde. Commercialized products which can be selected is XZ92741.

The object of the phosphorus-containing halogen-free flame retardant compound of the present invention is for flame retardancy. In order to ensure better overall performance like heat resistance and hydrolysis resistance of the cured products, the addition amount of the phosphorus-containing halogen-free flame retardant compound, based on the total 100 parts by weight of the epoxy resin, the active ester hardener and the phosphorus-containing halogen-free flame retardant compound, is 10∼150 parts by weight, more preferred to be 20∼120 parts by weight. Only if it can catalyze the reactions of epoxy functional groups and reduce the reaction temperature of curing system, no specific restriction is made to the curing accelerator and it is preferred to be one or more selected from imidazole compounds and derivatives thereof, piperidine compounds, Lewis acids and triphenylphosphine, or combinations thereof The imidazole compounds may be exemplified as 2-methylimidazole, 2-phenylimidazole or 2-ethyl-4-methylimidazole. The piperidine compounds may be exemplified as 2,3-diaminopiperidine, 2,5-diaminopiperidine, 2,6 -diaminopiperidine, 2,5-diamino, 2-amino-3-methyl-piperidine, 2-amino-4-4 methyl piperidine, 2-amino-3-nitropiperidine, 2-amino-5-nitropiperidine, or 4-dimethylaminopiperidine. The amount of the curing accelerator, based on the total 100 parts by weight of the epoxy resin, the active ester hardener and the phosphorus-containing halogen-free flame retardant compound, is 0.05∼1.0 part by weight.

If needed, an organic filler, an inorganic filler or a mixture of organic filler and inorganic filler can be further comprised in the present invention. No specific restriction is made to the filler added depending on the need. The inorganic filler can be one or more selected from crystalline silica, melting silica, spherical silica, hollow silica, glass powder, aluminum nitride, boron nitride, silicon carbide, aluminum hydroxide, titanium dioxide, strontium titanate, barium titanate, aluminum oxide, barium sulfate, talcum powder, calcium silicate, calcium carbonate and mica. The organic filler can be one or more selected from polytetrafluoroethylene powder, polyphenylene sulfide and polyether sulfone powder. In addition, there is no restriction on the shape and particle size of the inorganic filler. In general the particle size is 0.01-50µm, preferred to be 0.01-20µm, and more preferred to be 0.1-10µm. Inorganic filler with such range of particle size is easier to disperse in resin solution. Further, there is no restriction on the amount of the filler, which relative to the total 100 parts by weight of the epoxy resin, the active ester hardener and the phosphorus-containing halogen-free flame retardant compound, is 5-500 parts by weight, preferred to be 5-300 parts by weight, more preferred to be 5-200 parts by weight, and even more preferred to be 15-100 parts by weight.

The prepreg made by using the epoxy resin composition above includes a reinforce material and the epoxy resin composition attached thereon after beingimpregnated and dried. The reinforce material employs a reinforce material in the prior art like glass fiber cloth.

The copper-clad laminate made by using the epoxy resin composition above includes several laminated prepregs and copper foils covered on one or both sides of the laminated pregregs.

A varnish with certain concentration is prepared from the epoxy resin composition of the present invention. By impregnating the reinforce material and then drying it at a certain temperature, evaporating solvent and half curing the resin composition, the prepreg is obtained. And then one or more aforementioned prepregs are laminated in certain sequence. Copper foils are respectively covered on both sides of the laminated pregregs, cured in a hot press to prepare copper-clad laminates. The curing temperature is 150-250°C and the curing pressure is 25-60Kg/cm².

For the resulting copper-clad laminate above, the dielectric constant and dielectric dissipation factor, glass transition temperature and moisture-heat resistance thereof are measured and further explained and described in detail in the following examples.

### Example 1

100 parts by weight of 4'4-diaminodiphenylmethane tetraglycidyl amino resin KES-224(manufactured by KOLON Corporation, Korea, EEW is 125g/mol) was added into a container, and then 178.4 parts by weight of active ester hardener HPC-8000-65T (manufactured by DIC corporation, Japan, active ester equivalent is 223g/mol) was added and stirred well. 30 parts by weight of flame retardant, an aluminum salt of phosphate OP935 (manufactured by Clariant corporation, the content of phosphorus is 23%) and then a proper amount of DMAP and solvent toluene were added, stirred uniformly to form a varnish. The varnish above was impregnated with glass fiber cloth (model number 2116, the thickness is 0.08mm) and controlled to a proper thickness, and then the solvent was evaporated to obtain a prepreg. Several resulting prepregs were laminated, on both sides of which a copper foil was respectively covered, placed into a hot press and cured to produce the copper-clad laminate. For the copper-clad laminate obtained by curing in the hot press, the curing temperature thereof is 200°C, the curing pressure is 30Kg/cm² and the curing time is 90min.

### Example 2

100 parts by weight of resin MY0500 (manufactured by Hunstman Corporation, EEW is 110g/mol) was added into a container, and then 192.6 parts by weight of active ester hardener HPC-8000-65T (manufactured by DIC corporation, Japan, active ester equivalent is 223g/mol) was added and stirred well. 87.5 parts by weight of flame retardant, a DOPO modified phenolic resin (manufactured by DOW corporation, the content of phosphorus is 9%) was added. After stirring uniformly, a proper amount of DMAP and solvent toluene were added, stirred uniformly to form a varnish. The varnish above was impregnated with glass fiber cloth (model number 2116, the thickness is 0.08mm) and controlled to a proper thickness, and then the solvent was evaporated to obtain a prepreg. Several resulting prepregs were laminated, on both sides of which a copper foil was respectively covered, placed into a hot press and cured to produce the copper-clad laminate. For the copper-clad laminate obtained by curing in the hot press, the curing temperature thereof is 200°C, the curing pressure is 30Kg/cm² and the curing time is 90min.

### Example 3

100 parts by weight of 4'4 - diaminodiphenylmethane tetraglycidyl amino resin KES-224 (manufactured by KOLON Corporation, Korea, EEW is 125 g/mol) was added into a container, and then 178.4 parts by weight of active ester hardener HPC-8000-65T (manufactured by DIC corporation, Japan, active ester equivalent is 223g/mol) was added and stirred well. 69.6 parts by weight of flame retardant, a phenoxyphosphazene compound SPB-100 (manufactured by Otsuka corporation, Japan, the content of phosphorus is 12%) was added. After stirring uniformly, a proper amount of DMAP and solvent toluene were added, stirred uniformly to form a varnish. The varnish above was impregnated with glass fiber cloth (model number 2116, the thickness is 0.08mm) and controlled to a proper thickness, and then the solvent was evaporated to obtain a prepreg. Several resulting prepregs were laminated, on both sides of which a copper foil was respectively covered, placed into a hot press and cured to produce the copper-clad laminate. For the copper-clad laminate obtained by curing in the hot press, the curing temperature thereof is 200°C, the curing pressure is 30Kg/cm² and the curing time is 90min.

### Example 4

100 parts by weight of 4'4 - diaminodiphenylmethane tetraglycidyl amino resin KES-224 (manufactured by Monmentive KOLON Corporation, Korea, EEW is 125 g/mol) was added into a container, and then 178.4 parts by weight of active ester hardener HPC-8000-65T (manufactured by DIC corporation, Japan, active ester equivalent is 223g/mol) was added and stirred well. 119.3 parts by weight of flame retardant, a compound of phosphate ester PX-202 (manufactured by DAIHACHI corporation, Japan, the content of phosphorus is 8%) was added. After stirring uniformly, a proper amount of DMAP and solvent toluene were added, stirred uniformly to form a varnish. The varnish above was impregnated with glass fiber cloth (model number 2116, the thickness is 0.08mm) and controlled to a proper thickness, and then the solvent was evaporated to obtain a prepreg. Several resulting prepregs were laminated, on both sides of which a copper foil was respectively covered, placed into a hot press and cured to produce the copper-clad laminate. For the copper-clad laminate obtained by curing in the hot press, the curing temperature thereof is 200°C, the curing pressure is 30Kg/cm² and the curing time is 90min.

### Comparative example 1

100 parts by weight of o-cresol novolac epoxy resin N690 (manufactured by DIC Corporation, Japan, EEW is 205 g/mol) was added into a container, and then 108.8 parts by weight of active ester hardener HPC-8000-65T (manufactured by DIC corporation, Japan, active ester equivalent is 223g/mol) was added and stirred well. 32.5 parts by weight of flame retardant, an aluminum salt of phosphate OP930 (manufactured by Clariant corporation, the content of phosphorus is 23%) was added. After stirring uniformly, a proper amount of DMAP and solvent toluene were added, stirred uniformly to form a varnish. The varnish above was impregnated with glass fiber cloth (model number 2116, the thickness is 0.08mm) and controlled to a proper thickness, and then the solvent was evaporated to obtain a prepreg. Several resulting prepregs were laminated, on both sides of which a copper foil was respectively covered, placed into a hot press and cured to produce the copper-clad laminate. For the copper-clad laminate obtained by curing in the hot press, the curing temperature thereof is 200°C, the curing pressure is 30Kg/cm² and the curing time is 90min.

### Comparative example 2

100 parts by weight of 4'4-diaminodiphenylmethane tetraglycidyl amino resin KES-224 (manufactured by KOLON Corporation, Korea, EEW is 125 g/mol) was added into a container, and then 178.4 parts by weight of active ester hardener HPC-8000-65T (manufactured by DIC corporation, Japan, active ester equivalent is 223g/mol) was added and stirred well. 69.6 parts by weight of N,N-ethylene-bis(tetrabromophthalimide) BT-93W (manufactured by Albemarle corporation corporation, the content of bromine is 23%) was added. After stirring uniformly, a proper amount of DMAP and solvent toluene were added, stirred uniformly to form a varnish. The varnish above was impregnated with glass fiber cloth (model number 2116, the thickness is 0.08mm) and controlled to a proper thickness, and then the solvent was evaporated to obtain a prepreg. Several resulting prepregs were laminated, on both sides of which a copper foil was respectively covered, placed into a hot press and cured to produce the copper-clad laminate. For the copper-clad laminate obtained by curing in the hot press, the curing temperature thereof is 200°C, the curing pressure is 30Kg/cm² and the curing time is 90min.

Various physical property data of the copper clad laminates produced in the examples and comparative examples above are shown as table 1

**Table 1 physical property data of the copper clad laminates produced in each example and comparative example**

| component name | example 1 | example 2 | example 3 | example 4 | comparative example 1 | comparative example 2 |
|---|---|---|---|---|---|---|
| Tg(°C) | 210 | 215 | 215 | 205 | 175 | 185 |
| Dk (10GHz) | 3.8 | 3.9 | 3.7 | 3.9 | 3.9 | 3.9 |
| Df(10GHz) | 0.0095 | 0.0010 | 0.009 | 0.010 | 0.015 | 0.010 |
| moisture-heat resistance | 3/3 | 3/3 | 3/3 | 3/3 | 2/3 | 3/3 |
| flame retardancy | V-0 | V-0 | V-0 | V-0 | V-1 | V-0 |

The properties above are measured by methods as follows.
(1) Glass transition temperature (Tg): measured with DMA test, according to the DMA test method as stipulated under IPC-TM-6502.4.24.
(2) Dielectric constant and dielectric dissipation factor: measured according to SPDR method.
(3) Evaluation of moisture-heat resistance: the baseboard is evaluated after etching the copper foil on the surface of the copper clad laminate; the baseboard is placed in a pressure cooker, and subjected to the treatment of 120°C, 105KPa for 2h; then impregnated in a solder furnace at 288°C. The corresponding time is recorded when the baseboard is stratified and exploded. The evaluation is ended when the baseboard is in the solder furnace for more than 5min with no bubble or stratification occurring.
(4) Flame retardancy: measured according to UL94 standard method.

### Physical property analysis

It can be known from the physical property data in table 1, in the examples 1-4, when compared with the comparitive example 1 wherein the curing was carried out by using linear novolac epoxy resin and active ester, for using nitrogen-containing multifunctional epoxy resin active ester collectively to carry out the curing, the presence of nitrogen can exhibit a synergistic flame retardant effect together with phosphorus flame retardant, thereby the flame retardancy is good, and meanwhile, the water absorption of the obtained laminate materials is low, the dielectric performance and moisture-heat resistance are excellent, and the glass transition temperature is high. As above, the epoxy resin composition of the present invention includes an epoxy resin containing nitrogen in the molecular chain, an active ester hardener and a phosphorus-containing halogen-free flame retardant compound. Compared to a general copper foil baseboard, the copper-clad laminate made by using the epoxy resin composition of the invention possesses more excellent dielectric performance, a higher glass transition temperature and has good moisture-heat resistance as well, the halogen-free flame retardancy of which reaches V-0 degree and is applicable to the halogen-free high frequency field.

The examples above do not make any restriction on the contents of the composition of the present invention. Any slight alteration, equivalent change and modification according to the technical essence and the components or contents of the composition, all belong to the scope of the solution of the present invention.

## Claims

1. An epoxy resin composition, comprising components as follows: an epoxy resin containing 3 or more epoxy groups and nitrogen in the molecular chain, a phosphorus-containing halogen-free flame retardant compound and an active ester hardener; the amount of the epoxy resin containing 3 or more epoxy groups and nitrogen in the molecular chain is 100 parts by weight, the amount of the phosphorus-containing halogen-free flame retardant compound is 10∼150 parts by weight, the equivalent ratio of the amount of the active ester hardener, based on the ratio between epoxy equivalent and active ester equivalent, is 0.85∼1.2.

2. The epoxy resin composition of claim 1, wherein the epoxy resin containing 3 or more epoxy groups and nitrogen in the molecular chain is at least one of the epoxy resins having the following structural formula: 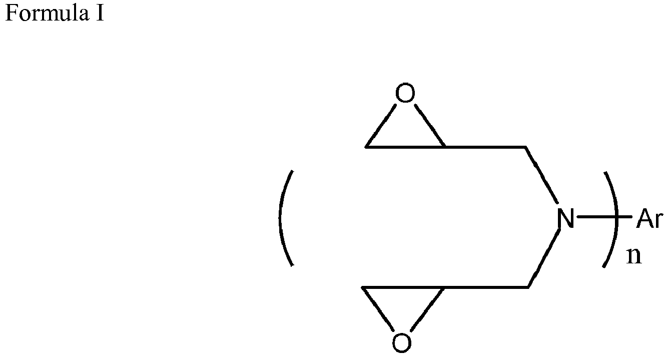 Wherein, n is an integer of 1∼3; Ar is: 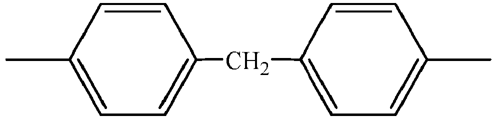 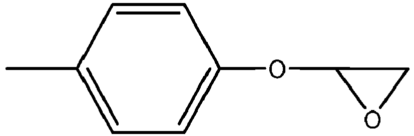 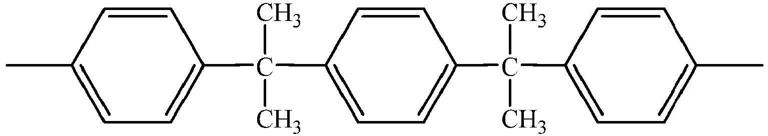 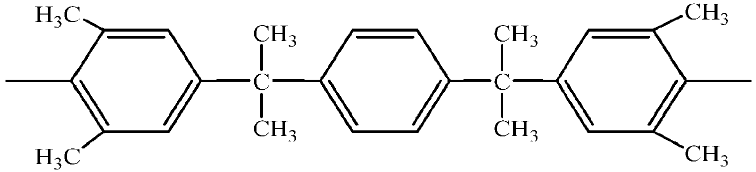 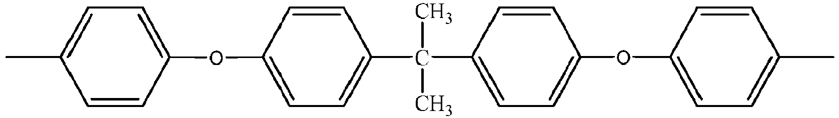 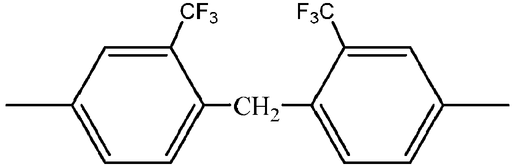 or

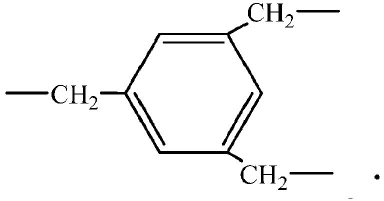

3. The epoxy resin composition of claim 1, wherein the phosphorus-containing halogen-free flame retardant compound is one or a mixture of phosphate ester compounds, phosphate salt compounds, phosphazene compounds, phosphaphenanthrene compounds and derivatives thereof, phosphorus-containing phenolic resins and phosphureted polycarbonates; the phosphorus content of the phosphorus-containing halogen-free flame retardant is 5∼30% by weight.

4. The epoxy resin composition of claim 1, wherein the active ester hardener is obtained by reacting a phenolic compound linked by an aliphatic cyclic hydrocarbon structure, a bifunctional carboxylic acid aromatic compound or an acidic halide and a mono-hydroxyl compound.

5. The epoxy resin composition of claim 4, wherein the amount of the bifunctional carboxylic acid aromatic compound or the acidic halide is 1mol, the amount of the phenolic compound linked by an aliphatic cyclic hydrocarbon structure is 0.05∼0.75mol, the amount of the mono-hydroxyl compound is 0.25∼0.95mol.

6. The epoxy resin composition of claim 1, wherein the structural formula of the active ester hardener is as follow: 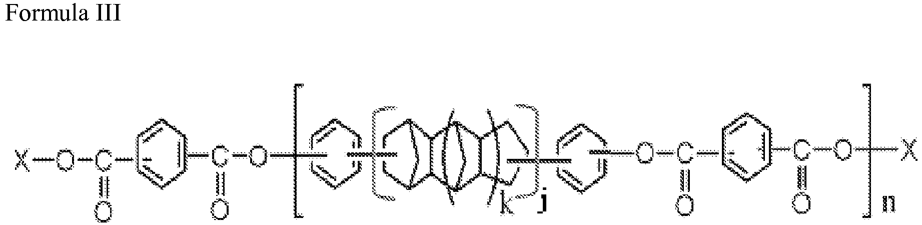 Wherein, X is a benzene ring or naphthalene ring, j is 0 or 1, k is 0 or 1, n is 0.25-2.5.

7. The epoxy resin composition of claim 1, further comprising a curing accelerator, the curing accelerator is one or a mixture of imidazole compounds and derivatives thereof, piperidine compounds, Lewis acids and triphenylphosphine.

8. The epoxy resin composition of claim 1, further comprising an organic filler, an inorganic filler or a mixture of organic filler and inorganic filler, the amount of the filler, relative to the total 100 parts by weight of the epoxy resin, the active ester hardener and the phosphorus-containing halogen-free flame retardant compound, is 5∼500 parts by weight.

9. The epoxy resin composition of claim 8, wherein the inorganic filler is one or more selected from crystalline silica, melting silica, spherical silica, hollow silica, glass powder, aluminum nitride, boron nitride, silicon carbide, aluminum hydroxide, titanium dioxide, strontium titanate, barium titanate, aluminum oxide, barium sulfate, talcum powder, calcium silicate, calcium carbonate and mica; the organic filler is one or more selected from polytetrafluoroethylene powder, polyphenylene sulfide, polyether sulfone powder.

10. A prepreg made by using the epoxy resin composition of claim 1, including a reinforce material and the epoxy resin composition attached thereon after being impregnated and dried.

11. A copper-clad laminate made by using the prepreg of claim 10, comprising several laminated prepregs and copper foils covered on one or both sides of the laminated pregregs.

## Patentansprüche

1. Epoxidharzzusammensetzung enthaltend die folgenden Komponenten: ein Epoxidharz enthaltend 3 oder mehr Epoxidgruppen und Stickstoff in der molekularen Kette, eine phosphorhaltige, halogenfreie Flammschutzkomponente und einen aktiven Esterhärter; die Menge des Epoxidharzes enthaltend 3 oder mehr Epoxidgruppen und Stickstoff in der molekularen Kette beträgt 100 Gewichtsteile, die Menge der phosphorhaltigen, halogenfreien Flammschutzkomponente beträgt 10-150 Gewichtsteile, das Äquivalentverhältnis der Menge des aktiven Esterhärters basierend auf dem Verhältnis zwischen dem Epoxidäquivalent und dem aktiven Esteräquivalent beträgt 0,85 - 1,2.

2. Epoxidharzzusammensetzung nach Anspruch 1, wobei das Epoxidharz enthaltend 3 oder mehr Epoxidgruppen und Stickstoff in der molekularen Kette mindestens ein Epoxidharz mit der folgenden Strukturformel ist: 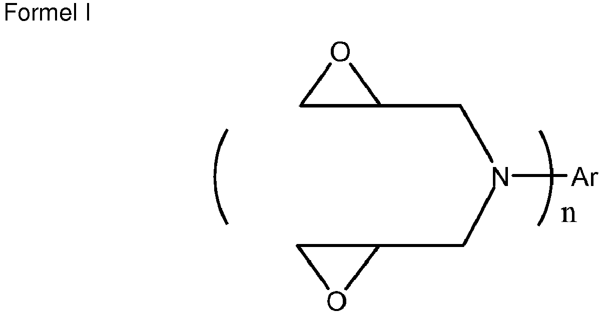 wobei n eine ganze Zahl von 1 - 3 ist; Ar ist: 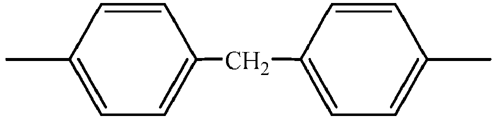 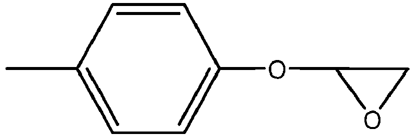 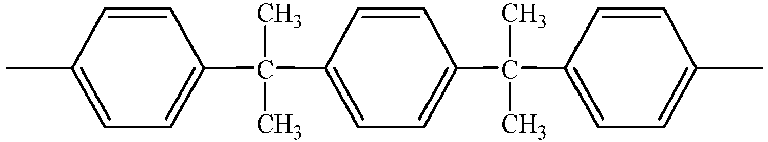 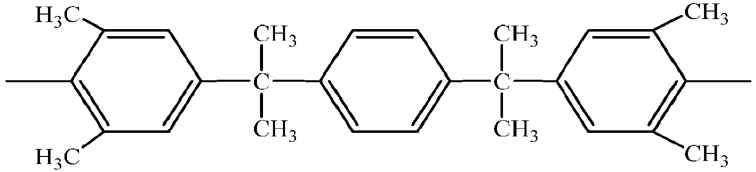 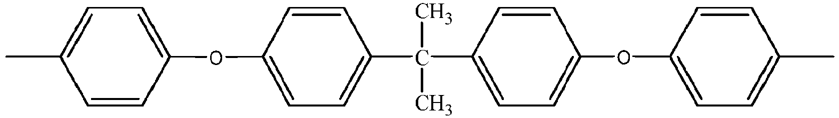 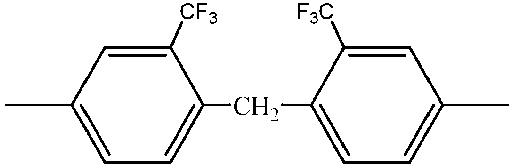 oder

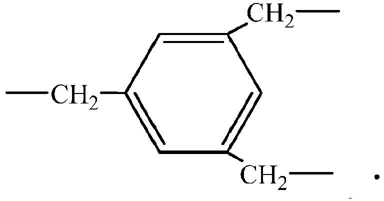

3. Epoxidharzzusammensetzung nach Anspruch 1, wobei die phosphorhaltige, halogenfreie Flammschutzkomponente eine oder eine Mischung von Phosphatesterverbindungen, Phosphatsalzverbindungen, Phosphazenverbindungen, Phosphaphenanthrenverbindungen und Derivaten davon, phosphorhaltigen Phenolharzen und Polycarbonate mit einwertigem Phosphor ist; der Phosphorgehalt der phosphorhaltigen, halogenfreien Flammschutzkomponente ist 5-30 Gew.-%.

4. Epoxidharzzusammensetzung nach Anspruch 1, wobei der aktive Esterhärter erhalten wird durch Reaktion einer phenolischen Verbindung verbunden mit einer aliphatischen zyklischen Kohlenwasserstoffstruktur, einer bifunktionalen aromatischen Carbonsäureverbindung oder einem sauren Halogenid und einer Monohydroxyverbindung.

5. Epoxidharzzusammensetzung nach Anspruch 4, wobei die Menge der bifunktionalen aromatischen Carbonsäureverbindung oder dem sauren Halogenid 1 mol ist, die Menge der phenolischen Verbindung verbunden mit einer aliphatischen zyklischen Kohlenwasserstoffstruktur 0,05 bis 0,75 mol ist, die Menge der Monohydroxyverbindung 0,25 bis 0,95 mol ist.

6. Epoxidharzzusammensetzung nach Anspruch 1, wobei die Strukturformel des aktiven Esterhärters wie folgt ist: 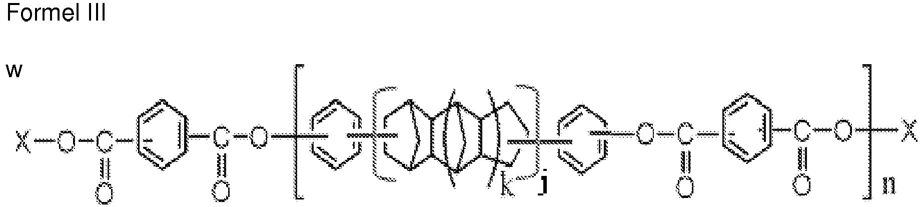 wobei X ein Benzolring oder ein Naphthalenring ist, j ist 0 oder 1, k ist 0 oder 1, n ist 0,25 bis 2,5.

7. Epoxidharzzusammensetzung nach Anspruch 1 ferner enthaltend einen Härtungsbeschleuniger, der Härtungsbeschleuniger ist einer oder eine Mischung von Imidazolverbindungen und Derivaten davon, Piperidinverbindungen, Lewissäuren und Triphenylphosphin.

8. Epoxidharzzusammensetzung nach Anspruch 1, ferner enthaltend einen organischen Füllstoff, einen anorganischen Füllstoff oder eine Mischung eines organischen Füllstoffs und eines anorganischen Füllstoffs, die Menge des Füllstoffs relativ zu den gesamten 100 Gewichtsteilen des Epoxidharzes, des aktiven Esterhärters und der phosphorhaltigen, halogenfreien Flammschutzkomponente ist 5-500 Gewichtsteile.

9. Epoxidharzzusammensetzung nach Anspruch 8, wobei der anorganische Füllstoff gewählt ist aus einem oder mehreren von kristallinem Silica, geschmolzenem Silica, sphärischem Silica, hohlem Silica, Glaspulver, Aluminiumnitrid, Bornitrid, Siliciumcarbid, Aluminiumhydroxid, Titandioxid, Strontiumtitanat, Bariumtitanat, Aluminiumoxid, Bariumsulfat, Talkumpulver, Kalziumsilicat, Kalziumcarbonat und Glimmer; der organische Füllstoff ist einer oder mehrere ausgewählt aus Polytetrafluoroethylen-Pulver, Polyphenylensulfid, Polyethersulfon-Pulver.

10. Prepreg hergestellt unter Verwendung der Epoxidharzzusammensetzung nach Anspruch 1, umfassend ein Verstärkungsmaterial und die daran nach Imprägnieren und Trocknen gebundene Epoxidharzzusammensetzung.

11. Kupferkaschierter Laminat hergestellt unter Verwendung des Prepregs nach Anspruch 10 umfassend mehrere laminierte Prepregs, die auf einer oder beiden Seiten Kupferfolien bedeckt sind.

## Revendications

1. Composition de résine époxy, comprenant les composants suivants : une résine époxy contenant 3 groupes époxy ou plus et de l'azote dans la chaîne moléculaire, un composé de produit ignifuge sans halogène et contentant du phosphore et un durcisseur d'ester actif ; la quantité de la résine époxy contenant 3 groupes époxy ou plus et de l'azote dans la chaîne moléculaire est de 100 parties en poids, la quantité du composé de produit ignifuge sans halogène et contenant du phosphore est de 10 à 150 parties en poids, le rapport équivalent de la quantité du durcisseur d'ester actif, par rapport au rapport entre un équivalent époxy et un équivalent ester actif est de 0,85 à 1,2.

2. Composition de résine époxy selon la revendication 1, dans laquelle la résine époxy contenant 3 groupes époxy ou plus et de l'azote dans la chaîne moléculaire est au moins l'une des résines époxy ayant la formule développée suivante : 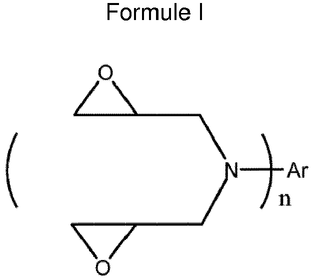 dans laquelle, n est un nombre entier de 1 à 3 ; Ar est : 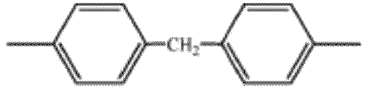 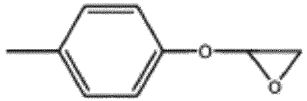 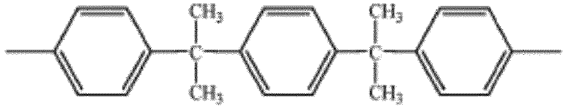 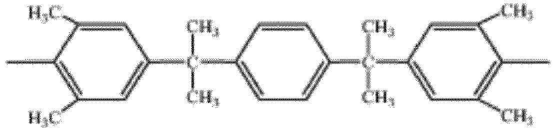 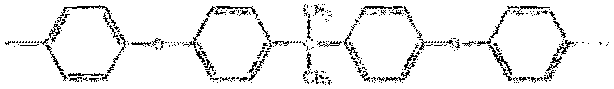 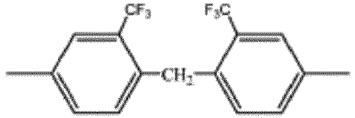 ou

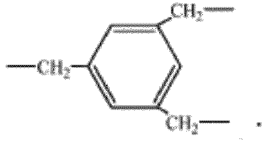

3. Composition de résine époxy selon la revendication 1, dans laquelle le composé de produit ignifuge sans halogène et contenant du phosphore est l'un ou un mélange de composés d'ester de phosphate, composés de sel de phosphate, composés de phosphazène, composés de phosphaphénanthrène, et leurs dérivés, résines phénoliques contenant du phosphore et polycarbonates phosphorés ; la teneur en phosphore du produit ignifuge sans halogène et contenant du phosphore est de 5 à 30 % en poids.

4. Composition de résine époxy selon la revendication 1, dans laquelle le durcisseur d'ester actif est obtenu par la mise en réaction d'un composé phénolique lié par une structure hydrocarbonée cyclique aliphatique, d'un composé aromatique d'acide carboxylique bifonctionnel ou d'un halogénure acide et d'un composé mono-hydroxyle.

5. Composition de résine époxy selon la revendication 4, dans laquelle la quantité du composé aromatique d'acide carboxylique bifonctionnel ou de l'halogénure acide est de 1 mole, la quantité du composé phénolique lié par une structure hydrocarbonée cyclique aliphatique est de 0,05 à 0,75 mole, la quantité du composé mono-hydroxyle est de 0,25 à 0,95 mole.

6. Composition de résine époxy selon la revendication 1, dans laquelle la formule développée du durcisseur d'ester actif est comme suit : 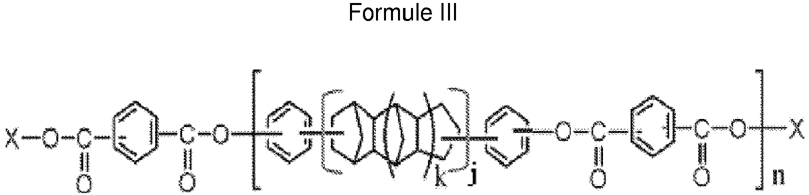 dans laquelle, X est un cycle benzène ou un cycle naphtalène, j vaut 0 ou 1, k vaut 0 ou 1, n vaut de 0,25 à 2,5.

7. Composition de résine époxy selon la revendication 1, comprenant en outre un accélérateur de durcissement, l'accélérateur de durcissement est l'un ou un mélange de composés imidazole et leurs dérivés, composés pipéridine, acides de Lewis et triphénylphosphine.

8. Composition de résine époxy selon la revendication 1, comprenant en outre une charge organique, une charge inorganique ou un mélange de charge organique et de charge inorganique, la quantité de la charge, par rapport à la totalité des 100 parties en poids de la résine époxy, du durcisseur d'ester actif, et du produit ignifuge sans halogène et contenant du phosphore, est de 5 à 500 parties en poids.

9. Composition de résine époxy selon la revendication 8, dans laquelle la charge inorganique est un ou plusieurs éléments choisis parmi la silice cristalline, la silice de fusion, la silice sphérique, la silice creuse, la poudre de verre, le nitrure d'aluminium, le nitrure de bore, le carbure de silicium, l'hydroxyde d'aluminium, le dioxyde de titane, le titanate de strontium, le titanate de baryum, l'oxyde d'aluminium, le sulfate de baryum, la poudre de talc, le silicate de calcium, le carbonate de calcium et le mica ; la charge organique est un ou plusieurs éléments choisis parmi la poudre de polytétrafluoroéthylène, le polysulfure de phénylène, la poudre de polyéther sulfone.

10. Préimprégné réalisé en utilisant la composition de résine époxy de la revendication 1, comportant un matériau de renforcement et la composition de résine époxy attachée sur celui-ci après avoir été imprégnée et séchée.

11. Stratifié cuivré réalisé en utilisant le préimprégné de la revendication 10, comprenant plusieurs préimprégnés stratifiés et des feuilles de cuivre recouvertes sur l'un ou les deux côtés des préimprégnés stratifiés.
